## Europäisches Patentamt

## European Patent Office

## Office européen des brevets

(11) Numéro de publication: **0 146 425**
**A1**

(12) ## DEMANDE DE BREVET EUROPEEN

(21) Numéro de dépôt: **84402173.3**

(22) Date de dépôt: **29.10.84**

(51) Int. Cl.⁴: **G 01 R 29/18**

(30) Priorité: **15.11.83 CA 441171**

(43) Date de publication de la demande: **26.06.85**
**Bulletin 85/26**

(84) Etats contractants désignés: **AT BE CH DE FR GB IT LI LU NL SE**

(71) Demandeur: **HYDRO-QUEBEC, 75, Boulevard Dorchester Ouest, Montréal Québec H2Z 1A4 (CA)**

(72) Inventeur: **Bouvrette, Michel, 2689 Rue Godard, Sainte Sophie (Quebec) JOR 1SO (CA)**

(74) Mandataire: **Martinet & Lapoux, 62, rue des Mathurins, F-75008 Paris (FR)**

(54) **Système et procédé de téléphasage pour identifier des phases dans un réseau polyphasé de transmission ou de distribution électrique.**

(57) L'identification d'une phase inconnue dans le réseau polyphasé (3) est obtenue en comparant celle-ci avec une phase de référence, la phase de référence et la phase inconnue fonctionnant à des tensions alternatives de même fréquence. La phase de référence est située à un emplacement (4) du réseau éloigné d'un emplacement (5) du réseau où se trouve la phase inconnue. Le système de téléphasage comporte un premier dispositif (1) relié à la phase de référence et un second dispositif (2) relié à la phase inconnue. Chacun des dispositifs comprend un modem pour établir une liaison téléphonique (6) entre les dispositifs, et un transformateur et un circuit de mise en forme, ou un bâton de phasage et un adaptateur de bâton de phasage, pour produire un signal numérique qui est représentatif de la tension alternative de la phase de référence ou de la phase inconnue. Le signal numérique représentatif de la tension de la phase de référence est transmis via les deux modems et la liaison téléphonique au second dispositif (2). Le second dispositif est muni de circuits pour compenser un temps de propagation du signal reçu représentatif de la tension de la phase de référence dans la liaison (6) et de circuits pour identifier la phase inconnue en détectant un angle de phase entre la tension de la phase de référence et la tension de la phase inconnue après compensation du temps de propagation.

## SYSTEME ET PROCEDE DE TELEPHASAGE POUR IDENTIFIER DES PHASES DANS UN RESEAU POLYPHASE DE TRANSMISSION OU DE DISTRIBUTION ELECTRIQUE

La présente invention concerne un système et un procédé de téléphasage pour identifier une phase inconnue dans un réseau polyphasé de transmission ou de distribution d'énergie électrique, par exemple, un réseau triphasé, par comparaison de la phase inconnue avec une phase connue de ce réseau polyphasé. Ce système et ce procédé sont spécialement conçus pour être utilisés lorsque la phase connue est située à un emplacement du réseau triphasé éloigné par rapport à un autre emplacement de ce réseau où se trouve la phase inconnue.

Un tel système et un tel procédé de téléphasage permettent d'identifier des phases inconnues, par exemple, lors de l'addition d'une ligne ou de la modification du parcours d'une ligne dans un réseau triphasé, lorsque ces phases inconnues sont éloignées des phases connues de ce réseau. Un tel système et un tel procédé de téléphasage peuvent également avantageusement permettre au personnel responsable de la distribution d'électricité aux consommateurs d'identifier les phases des artères en milieu rural ou urbain.

Jusqu'à présent, l'identification de telles phases inconnues dans un réseau triphasé de transmission ou de distribution d'énergie électrique pouvait s'effectuer par l'un ou l'autre des procédés suivants dont le choix dépendait des variantes d'une application donnée. Quelques uns de ces procédés consistaient en une injection sur une phase d'une basse tension via un transformateur de distribution, en une injection sur une phase d'un signal haute fréquence, en une fermeture monophasée de disjoncteurs ou de sectionneurs installés sur le réseau triphasé, ou encore en une utilisation de bâtons de phasage, d'une tension de référence du réseau de distribution, ou de transformateurs de tension.

Certains de ces procédés exigeaient d'être réalisées hors réseau, ce qui pouvait se traduire par une absence de tension chez l'abonné d'une compagnie distributrice d'électricité, pour de longues périodes (une à plusieurs heures). De plus, dans la plupart

0146425

- 2 -

des cas, ces procédés comportaient des risques pour le personnel et l'équipement, et nécessitaient un personnel considérable.

On connaît également, d'après le brevet canadien CA-A-1.056.309, un système de communication utilisant l'une des lignes de transmission d'énergie électrique d'un réseau triphasé. Cependant, le but d'un tel système n'est pas d'identifier des phases inconnues d'un réseau triphasé, mais d'établir une liaison de communication entre plusieurs points de ce réseau triphasé par l'intermédiaire de l'une de ses lignes de transmission d'énergie électrique. Cela implique évidemment que les phases, aux points d'interconnection de ce système de communication avec le réseau triphasé, doivent être connues afin d'établir la liaison désirée entre ces différents points.

D'autres dispositifs pour déterminer la séquence des phases sont également décrits dans le brevet canadien CA-A-1.054.225 et les brevets américains US-A-3.156.868, US-A-3.555.417 et US-A-3.764.904. Cependant, de tels dispositifs ne permettent pas l'identification des phases d'un système triphasé lorsque les trois phases de ce système sont inconnues.

La présente invention a pour but de fournir un système et un procédé de téléphasage qui, tel que mentionné plus haut, sont capables d'identifier une phase inconnue dans un réseau polyphasé de transmission ou de distribution d'énergie électrique, par comparaison de cette phase inconnue avec une phase connue située à un emplacement du réseau éloigné par rapport à un autre emplacement de ce réseau où se trouve la phase inconnue. Avantageusement, les système et procédé de téléphasage sont fonctionnels pour identifier une phase inconnue d'un réseau polyphasé lorsque ce réseau est sous tension, et diminuent ainsi considérablement les risques pour le personnel et l'équipement. L'abonné de la compagnie distributrice d'électricité ne sera donc plus affecté par l'emploi des procédés antérieurs décrits ci-dessus.

A ces fins, un système de téléphasage selon l'invention est tel que défini dans la revendication 1.

Un procédé de téléphasage pour la mise en oeuvre d'un système de téléphasage selon l'invention est tel que défini dans la revendication 30.

De préférence, la liaison de communication est une liaison téléphonique et les moyens pour établir cette liaison peuvent comprendre un modem associé à chacun des premier et second dispositifs.

D'autres avantages et caractéristiques de la présente invention ressortiront de la description suivante d'un mode de réalisation préféré, donnée à titre d'exemple non limitatif seulement, en référence aux dessins annexés correspondants, dans lesquels :

Les Figures 1 et 2 illustrent schématiquement différents éléments d'un système de téléphasage selon deux variantes de l'invention, ainsi que le raccordement de ce système à la phase inconnue et à la phase de référence ;

La Figure 3 est un bloc-diagramme du circuit d'une unité de référence qui fait partie du système de téléphasage illustré aux Figures 1 et 2 ; et

La Figure 4 est un bloc-diagramme du circuit d'une unité de vérification faisant également partie du système de téléphasage des Figures 1 et 2.

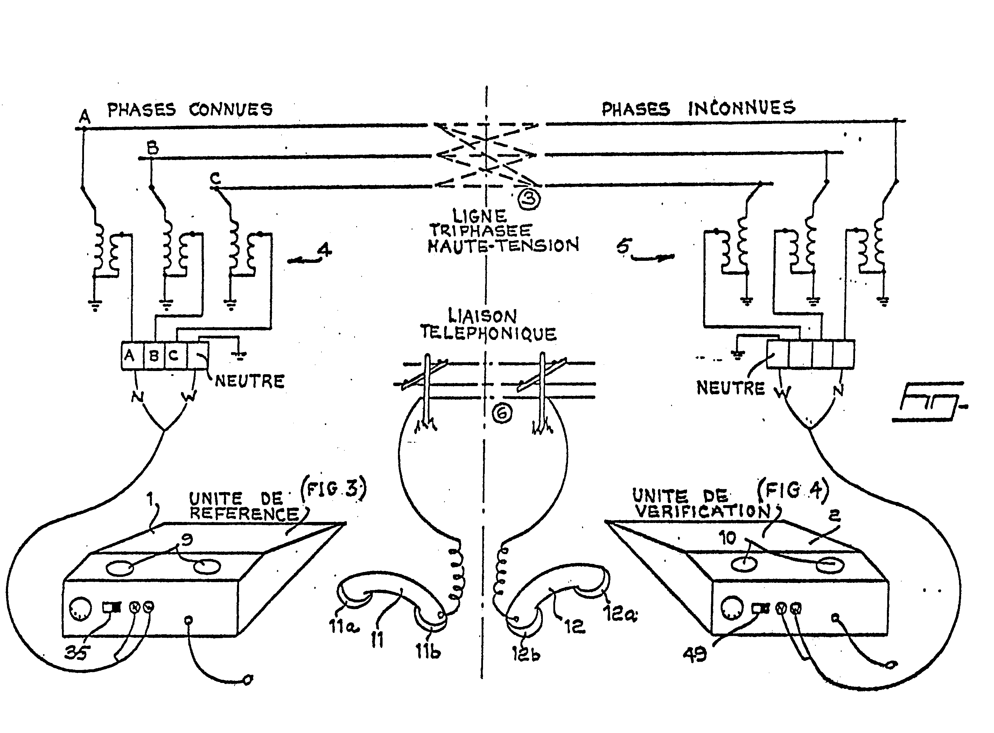

Tel qu'illustré aux Figures 1 et 2, le système de téléphasage comprend une unité de référence 1 et une unité de vérification 2. Ces deux unités 1 et 2 peuvent être reliées entre elles grâce à une liaison téléphonique bidirectionnelle illustrée schématiquement en 6. Cette liaison téléphonique est établie à l'aide de deux récepteurs téléphoniques illustrés schématiquement par des combinés 11 et 12 ayant des écouteurs 11a et 12a et des microphones 11b et 12b coopérant avec des coupleurs acoustiques 9 et 10 incorporés dans des modems tels qu'il sera expliqué plus loin.

Ce type de liaison à l'aide de coupleurs acoustiques rend le système de téléphasage sensible aux bruits sonores environnants. Pour remédier à ce problème, chaque coupleur acoustique peut être monté dans un boîtier insonorisé muni d'un accès pour le combiné du récepteur téléphonique correspondant.

Au cas où il n'y aurait pas de récepteur téléphonique aux emplacements où sont situées les unités de référence et de vérification, il serait possible d'équiper des véhicules avec un récepteur téléphonique portatif disponible sur le marché. Cela faciliterait également l'identification des phases des artères en milieu rural ou urbain, du réseau de distribution d'une compagnie distribuant de l'électricité à des abonnés.

Tel qu'illustré aux Figures 1 et 2, l'unité de référence 1 est localisée à un emplacement d'un réseau triphasé haute tension de transmission ou de distribution d'énergie électrique où les phases A, B et C d'une ligne triphasée à haute tension 3 de ce réseau fonctionnant à une fréquence nominale de 60Hz, par exemple, ou bien de 50Hz, sont connues, et l'unité de vérification 2 à un emplacement où l'on désire connaître les phases de cette ligne 3 qui sont inconnues à cet endroit.

Les unités de référence et de vérification pourraient être branchées à une phase de lignes triphasées différentes du réseau triphasé ci-dessus mentionné. Il faudrait alors tenir compte du déphasage produit par des transformateurs de puissance, s'il y a lieu.

L'unité de référence 1 est reliée à une phase connue de la ligne 3, par exemple la phase A nommée ci-après phase de référence, par l'intermédiaire d'un transformateur de tension 4 disponible ou spécialement prévu pour réduire le niveau de la haute tension de cette phase de référence à un niveau utilisable par l'unité de référence 1.

Un signal à fréquence nominale, par exemple de 60 Hz, ou bien de 50Hz, correspondant à la tension de cette phase de référence est produit par l'unité de référence 1 à partir de cette haute tension réduite et est ensuite transmis par l'unité de référence 1 à l'unité de vérification 2 par l'intermédiaire de la liaison téléphonique 6, tel qu'il sera explicité plus en détail ci-après.

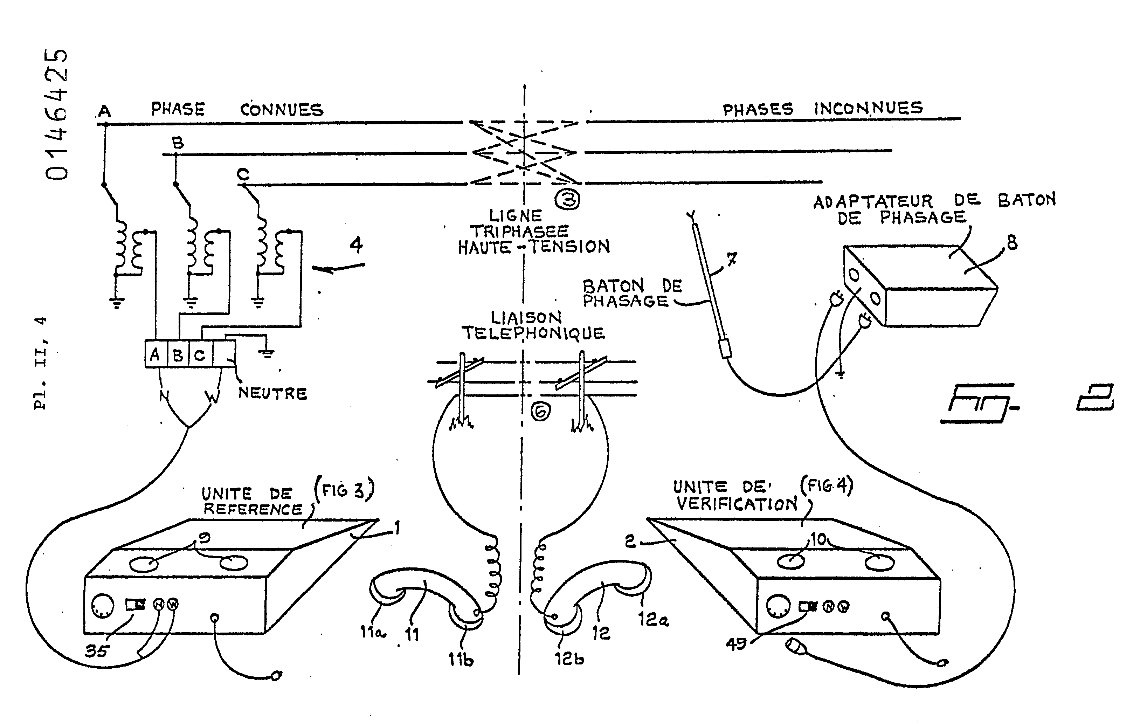

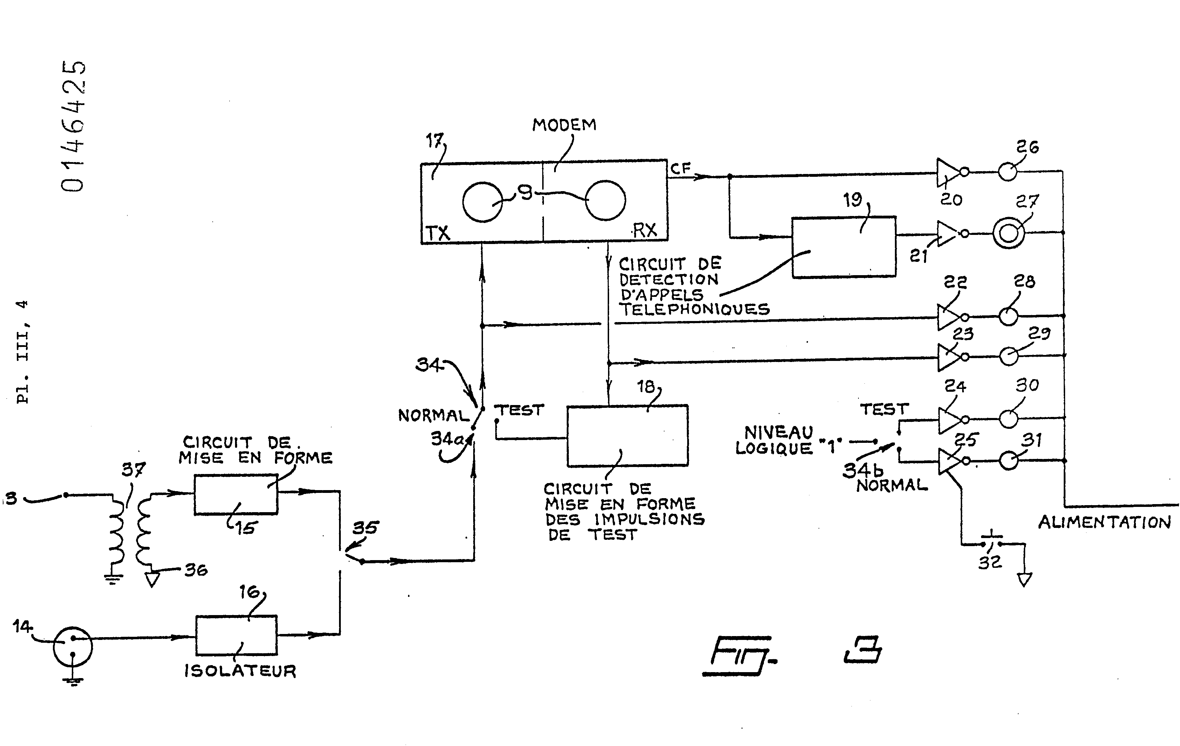

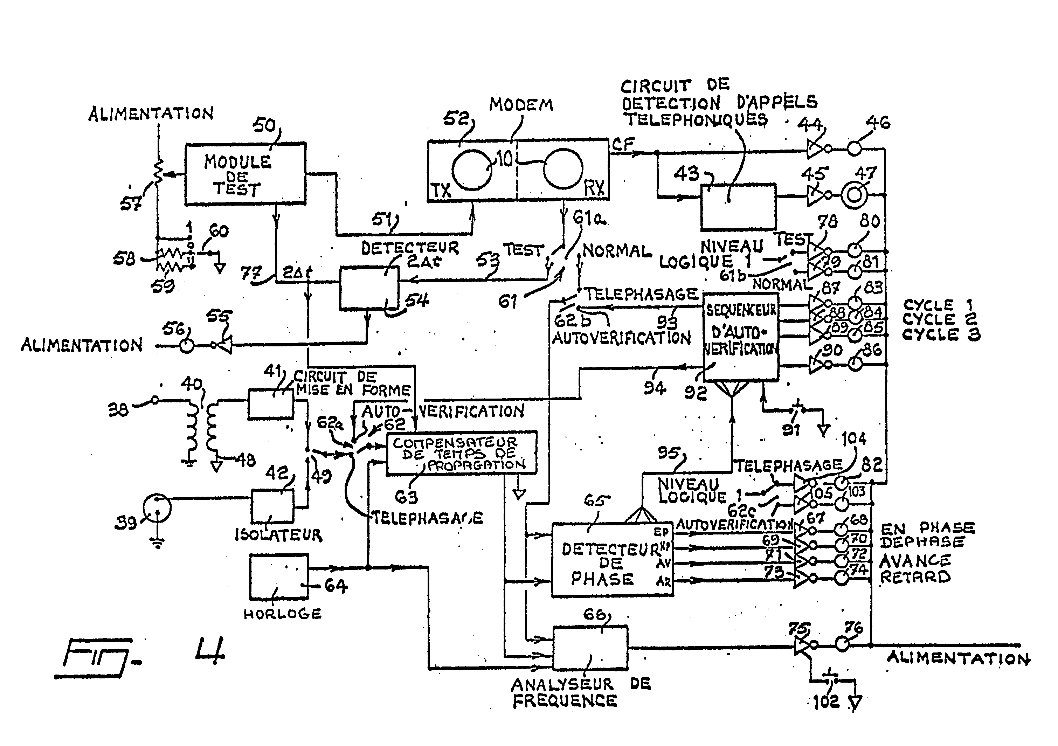

Tel qu'illustré à la Figure 1, l'unité de vérification 2 est reliée à une phase inconnue de la ligne 3 par l'intermédiaire d'un transformateur de tension 5 disponible ou spécialement prévu pour réduire le niveau de la haute tension de la phase inconnue à un niveau utilisable par l'unité de vérification 2. Cette unité de vérification est spécialement adaptée pour comparer un signal de fréquence nominale correspondant à la tension de cette phase inconnue, produit par l'unité de vérification à partir de la tension réduite de la phase inconnue, avec le signal de fréquence nominale correspondant à la tension de la phase de référence reçue de l'unité de référence 1, afin de déterminer si les tensions alternatives de phase inconnue et de la phase de référence sont en phase ou non, tel qu'il sera explicité en référence aux Figures 3 et 4.

Bien que, tel qu'illustré à la Figure 1, la phase de référence et la phase inconnue proviennent chacune d'une ligne haute tension par l'intermédiaire d'un transformateur abaisseur de tension 4 ou 5 relié directement à cette ligne haute tension, chacune de ces phases pourrait également provenir du secondaire d'un transformateur de puissance abaisseur de tension déjà en opération par l'intermédiaire d'un transformateur abaisseur de tension 4 ou 5. Il faudrait cependant, dans ce dernier cas, tenir compte du décalage angulaire produit par le transformateur de puissance, s'il y a lieu.

Une autre variante pour l'acquisition de la phase de référence ou de la phase inconnue réside dans l'utilisation d'un bâton de phasage lorsque le niveau de tension le permet, c'est-à-dire jusqu'à une tension d'environ 120 kV et que des transformateurs pour abaisser la haute tension à un niveau acceptable ne sont pas disponibles. Cette variante est représentée à la Figure 2 des dessins où la tension de la phase inconnue est détectée par un bâton de phasage 7 branché directement à la haute tension de cette phase inconnue. Un bâton de phasage est bien connu de l'homme de l'art et disponible sur le marché et, pour cette raison, ne sera donc pas décrit davantage.

La tension à la sortie du bâton de phasage 7, qui correspond à la tension de la phase à laquelle ce bâton de phasage est branché, est transmise à l'unité de vérification 2 par l'intermédiaire d'un adaptateur de bâton de phasage 8. Comme la tension provenant du bâton de phasage est de l'ordre du volt, cette tension est amplifiée par l'adaptateur de bâton de phasage 8. Cet adaptateur de bâton de phasage comprend également un circuit de mise en forme pour convertir la tension à la sortie du bâton de phasage en un signal numérique de même fréquence que cette tension de sortie, c'est-à-dire de même fréquence nominale que la tension de la phase à laquelle est branché le bâton de phasage 7.

L'adaptateur de bâton de phasage 8 comprend également un circuit pour corriger un déphasage qui existe entre la tension d'entrée et la tension de sortie du bâton de phasage 7. Etant donné que ce déphasage est fonction du nombre de bâtons de phasage utilisés, l'adaptateur de bâton de phasage 8 peut en outre comporter un commutateur qui est positionné selon le nombre de bâton de phasage utilisés de manière à corriger de façon appropriée le déphasage produit par ce ou ces bâtons. Il est à noter que l'utilisation d'un bâton de phasage facilitera beaucoup les opérations de téléphasage au niveau du réseau de distribution d'une compagnie distributrice d'électricité.

Les circuits de l'unité de référence et de l'unité de vérification seront maintenant explicités en détail en référence aux Figures 3 et 4 des dessins, respectivement.

L'unité de référence 1 (Figures 1 et 2) comporte, tel qu'illustré à la Figure 3, deux entrées 13 et 14, l'une 13 pour recevoir la tension de la phase de référence lorsque celle-ci provient d'un transformateur abaisseur de tension, par exemple d'un transformateur 4 des Figures 1 et 2, par l'intermédiaire de la liaison N de ces deux Figures et l'autre 14 pour recevoir la tension de cette phase de référence lorsque celle-ci provient d'un bâton de phasage, par l'intermédiaire d'un adaptateur de bâton de phasage tel que décrit en référence à la Figure 2.

L'entrée 13 est reliée à la borne d'un enroulement primaire d'un transformateur abaisseur de tension 37, cet enroulement primaire ayant son autre borne reliée à la terre par l'intermédiaire de la connexion W de l'unité de référence des Figures 1 et 2. Un enroulement secondaire de ce transformateur 37 a une borne reliée à la masse d'une alimentation de courant continu de l'unité de référence 1 illustrée schématiquement en 36, et transmet la tension réduite de la phase de référence à un circuit de mise en forme 15 qui transforme le signal sinusoïdal présent au secondaire du transformateur 37 et correspondant à la tension de la phase de référence en un signal numérique à une même fréquence que la fréquence nominale du signal sinusoïdal.

L'entrée 14, qui peut être connectée à la sortie d'un adaptateur de bâton de phasage, est isolée électriquement du reste du circuit de l'unité de référence par un isolateur 16 qui peut être, par exemple, un isolateur optique.

Un commutateur 35, également représenté schématiquement aux Figures 1 et 2, permet de sélectionner la sortie du circuit 15 lorsque la tension de la phase de référence provient d'un transformateur abaisseur de tension, par exemple le transformateur 4 des Figures 1 et 2, ou la sortie de l'isolateur 16 lorsque la tension de la phase de référence provient d'un bâton de phasage par l'intermédiaire de son adaptateur.

Le signal numérique de fréquence nominale à la sortie du circuit de mise en forme 15 ou à la sortie de l'isolateur 16 est transmis par l'intermédiaire du commutateur 35 et de premiers contacts 34a d'un double commutateur 34 lorsque celui-ci est en position "NORMAL", vers une partie de transmission TX d'un modem 17 pour être ensuite modulé et transmis à l'unité de vérification 2 par l'intermédiaire du coupleur acoustique correspondant 9 de ce modem et de la liaison téléphonique, comme décrit précédemment.

L'unité de référence 1 comprend avantageusement une série de lampes ou de diodes électroluminescentes (LED) pour indiquer son fonctionnement.

Tel qu'illustré à la Figure 3, une lampe ou LED indiquée schématiquement en 26 s'allume lorsqu'un signal CF généré par le modem 17 indique que ce modem reçoit une porteuse ayant des niveau et fréquence convenables, ce qui signifie que les deux combinés téléphoniques 11 et 12 sont bien accouplés aux coupleurs acoustiques correspondants 9 et 10 des unités de référence et de vérification. Le signal CF contrôle l'allumage de la lampe ou LED 26 par l'intermédiaire d'un inverseur 20. Lorsque le combiné 12 du récepteur téléphonique mentionné ci-dessus est découplé des coupleurs acoustiques 10 de l'unité de vérification 2 des Figures 1 et 2, le modem 17 ne reçoit plus la porteuse et le signal CF indique cette condition à un circuit de détection d'appels téléphoniques 19 qui active un avertisseur sonore 27 par l'intermédiaire d'un inverseur 21 pour indiquer un appel téléphonique, c'est-à-dire pour indiquer que l'opérateur de l'unité de vérification veut communiquer avec l'opérateur de l'unité de référence.

Par conséquent, comme l'unité de vérification est munie d'un circuit semblable pour la détection d'appels téléphoniques, et d'un avertisseur sonore correspondant lorsque l'opérateur de l'une des unités 1 et 2 veut communiquer avec l'opérateur de l'autre unité, il n'a qu'à découpler le combiné téléphonique correspondant des coupleurs acoustiques de l'unité correspondante. L'autre opérateur en est aussitôt averti grâce à l'avertisseur sonore de l'unité correspondante, car, à ce moment, celle-ci ne reçoit plus l'onde porteuse provenant de l'unité dont les coupleurs acoustiques sont découplés du combiné téléphonique et active son avertisseur sonore.

Deux autres lampes ou LED représentées schématiquement en 28 et 29 et deux inverseurs associés 22 et 23 sont également prévus pour indiquer si un signal est transmis vers la partie de transmission TX du modem 17 qui comprend le coupleur acoustique 9 couplé au microphone 11b du combiné 11, et si un signal est reçu par une partie de réception RX de ce modem 17, qui comprend le coupleur acoustique 9 couplé à l'écouteur 11a du combiné 11 des Figures 1 et 2, respectivement.

Deux lampes ou LED représentées schématiquement en 30 et 31 et deux inverseurs correspondants 24 et 25 sont reliés par l'intermédiaire de seconds contacts 34b du double commutateur 34, de façon à indiquer la position "NORMAL" ou "TEST" du commutateur 34. Le double commutateur 34 peut être ainsi constitué par deux simples commutateurs superposés 34a et 34b ayant chacun deux contacts fixes et un contact mobile, les contacts mobiles étant mobiles simultanément. Des double et triple commutateurs cités dans la suite ont également une structure analogue.

Un bouton-poussoir 32 connecté à des entrées de contrôle· des inverseurs 20 à 25 permet de vérifier le fonctionnement des lampes ou LED 26 et 28 à 31 et de l'avertisseur sonore 27 de façon simultanée. Cette connexion du bouton-poussoir 32 avec les entrées de contrôle des inverseurs 20 à 25 a été illustrée seulement pour l'inverseur 25, à des fins de simplification de la Figure 3.

Lorsque le commutateur 34 est en position "TEST", un signal composé, de préférence, d'une série d'impulsions de test, est transmis par l'unité de vérification 2 à travers la liaison téléphonique 6 pour mesurer un temps de propagation moyen de communications à travers la liaison téléphonique entre les deux unités et est reçu par la partie de réception RX du modem 17, remis en forme par un circuit de mise en forme des impulsions de test 18 et retransmis à l'unité de vérification par la partie de transmission TX du modem 17, via le commutateur 34.

Tel qu'illustré à la Figure 4 des dessins, l'unité de vérification 2 des Figures 1 et 2 comporte une entrée 38 associée à un transformateur abaisseur de tension 40 et à un circuit de mise en forme 41 pour recevoir la tension de la phase inconnue par l'intermédiaire, par exemple de la liaison N de l'unité de vérification 2 de la Figure 1, lorsque celle-ci provient du transformateur abaisseur de tension 5, de la Figure 1. Le transformateur 40 a un enroulement primaire relié à la terre par l'intermédiaire de la liaison W de l'unité de vérification 2 de la Figure 1 et un enroulement secondaire relié à la masse d'une alimentation en courant continu de l'unité de vérification illustrée schématiquement en 48. Le circuit 41 a une structure similaire à celle du circuit 15 de l'unité de référence illustré à la Figure 3. L'unité de vérification comporte également une autre entrée 39 qui peut être connectée à l'adaptateur de bâton de phasage 8 de la Figure 2 pour recevoir le signal numérique de fréquence nominale délivré par cet adaptateur et correspondant à la tension de phase inconnue lorsqu'un bâton de phasage est utilisé. Cette entrée 39 est isolée du reste du circuit de l'unité de vérification par un isolateur 42 qui peut être du même type que l'isolateur 16 de l'unité de référence illustré à la Figure 3.

Un commutateur 49, également illustré schématiquement aux Figures 1 et 2, permet de sélectionner la sortie du circuit 41 ou la sortie de l'isolateur 42 selon que la tension de la phase inconnue provient d'un transformateur 5 de la Figure 1 ou du bâton de phasage 7 de la Figure 2 par l'intermédiaire de son adaptateur de bâton de phasage 8.

Lorsque l'unité de vérification effectue un téléphasage, le signal numérique à fréquence nominale à la sortie du circuit 41 ou de l'isolateur 42 est transmis par l'intermédiaire du commutateur 49 à une entrée d'un circuit à retard 63 à travers des premiers contact 62a d'un triple commutateur 62 en position "TELEPHASAGE".

Le circuit à retard 63 retarde, comme cela apparaîtra à la lecture de la description qui suit, le signal numérique de fréquence nominale représentatif de la phase inconnue transmis par l'intermédiaire du commutateur 49, d'une durée correspondant à une valeur moyenne du temps de propagation du signal numérique de fréquence nominale représentatif de la tension de la phase de référence transmis par l'unité de référence 1 à travers la liaison téléphonique 6 pour ainsi compenser le retard moyen dû à la transmission. Cette compensation est effectuée à partir d'un signal 2 Δt appliqué à une entrée du circuit à retard 63 par un module de test 50 et d'un signal d'horloge numérique de 100 kHz produit par une horloge 64. La nature du signal 2 Δt et le fonctionnement du circuit à retard 63 seront explicité plus en détail ci-après.

Tel qu'illustré à la Figure 4, lors d'une opération de téléphasage, le signal numérique à fréquence nominale représentatif de la tension de la phase de référence est reçu par une partie de réception RX d'un modem 52 qui comprend le coupleur acoustique 10 branché à l'écouteur 12a du combiné 12, et est transmis à une entrée d'un détecteur de phase 65 par l'intermédiaire de premiers contacts 61a d'un double commutateur 61 en position "NORMAL" et de seconds contacts 62b du triple commutateur 62 en position "TELEPHASAGE".

Chacun des cycles du signal numérique à fréquence nominale à la sortie du circuit à retard 63 est comparé dans le détecteur 65 à chacun des cycles du signal numérique à fréquence nominale reçu par la partie de réception RX du modem 52. Le détecteur de phase 65 comporte un circuit d'inhibition de glissement de phase prévu pour compenser tout glissement de phase du signal numérique à fréquence nominale représentatif de la tension de la phase de référence se produisant lors de sa transmission à travers la liaison téléphonique, ce glissement influençant de façon aléatoire le temps de propagation du signal numérique à fréquence nominale transmis à travers la ligne téléphonique, tel qu'il apparaîtra plus clairement à la lecture de la description qui suit.

Le résultat de la comparaison par le détecteur de phase 65 des deux signaux numériques à fréquence nominale représentatifs respectivement de la tension de la phase de référence et de la tension de la phase inconnue est indiqué à des sorties EP, HP, AV et AR du détecteur de phase 65. Lorsque les deux signaux comparés sont en phase, une sortie EP commande l'allumage d'une lampe ou LED représentée schématiquement en 68 par l'intermédiaire d'un inverseur 67. Lorsque les signaux comparés sont complètement déphasés, une lampe ou LED représentée schématiquement en 70 est allumée par une sortie HP du détecteur 65 par l'intermédiaire d'un inverseur 69.

De la même façon, des lampes ou LED représentées schématiquement en 72 et 74 sont allumées par des sorties AV et AR du détecteur 65 par l'intermédiaire d'inverseurs 71 et 73, respectivement, selon que la phase du signal représentatif de la tension de la phase inconnue est en avance ou en retard par rapport à la phase du signal représentatif de la phase de référence dont le temps de propagation dû à sa transmission par l'intermédiaire de la liaison téléphonique a été préalablement compensé.

Les signaux de tension de la phase de référence et de la phase inconnue sont transformés de la même façon en signaux numériques à fréquence nominale par des adaptateurs de bâton de phasage ou par les circuits de mise en forme 15 et 41 des unités de référence et de vérification des Figures 3 et 4, en tenant compte des alternances positives ou négatives des tensions de ces phases de référence et inconnue. La détermination de la phase par le détecteur 65 de la Figure 4 peut donc être effectuée au niveau du cycle complet.

De cette façon, lorsque les signaux comparés par le détecteur de phase 65 sont déphasés l'un par rapport à l'autre de 180°, et donc inversés, la lampe ou LED 70 est allumée pour indiquer que les deux signaux comparés ne sont pas en phase et ainsi éviter toute ambiguïté. Puisque la détermination de la phase se fait au niveau du cycle, il est possible, tel que mentionné plus haut, de déterminer si le signal à fréquence nominale avec la phase inconnue est en avance ou en retard par rapport au signal à fréquence nominale avec la phase de référence. Aucune fausse interprétation n'est donc possible.

Tel que décrit précédemment, une seule phase de référence est comparée avec une seule phase inconnue à la fois, de façon à éviter toute confusion.

Le signal numérique à fréquence nominale représentatif de la tension de la phase de référence délivré par le modem 52 et le signal numérique représentatif de la tension de la phase inconnue délivré par le compensateur 63, ainsi que le signal produit par l'horloge 64 sont appliqués à un analyseur de fréquence 66 qui allume une lampe ou LED 76 par l'intermédiaire d'un inverseur 75 lorsque la fréquence des signaux représentatifs de la phase de référence et de la phase inconnue est comprise par exemple entre 55 et 65 Hz pour une fréquence nominale de 60 Hz, de façon à éliminer les risques de comparaison de signaux numériques ayant une fréquence autre que la fréquence du réseau.

Etant donné que les signaux numériques à fréquence nominale représentatifs de la tension de la phase de référence et de la tension de la phase inconnue sont comparés dans le temps, et que la liaison téléphonique produit un retard entre la transmission et la réception du signal à fréquence nominale avec la phase de référence, il faut donc, comme déjà mentionné, compenser ce retard pour ainsi éviter toute erreur dans la détection de l'angle de phase entre la tension de la phase de référence et la tension de la phase inconnue et pour ainsi déterminer, de façon exacte, la nature de la phase inconnue. La méthode utilisée pour compenser ce retard sera explicitée en détail ci-après.

Une valeur moyenne du temps de propagation du signal à fréquence nominale représentatif de la tension de la phase de référence, de l'unité de référence à l'unité de vérification à travers la liaison téléphonique 6 des Figures 1 et 2, est déterminée en mettant le commutateur 61 de la Figure 4 et le commutateur 34 de la Figure 3 en position "TEST". Le module de test 50 génère alors automatiquement d'une façon cyclique une série d'impulsions de test fournies par une liaison 51 à une partie de transmission TX du modem 52, qui comprend le coupleur acoustique 10 couplé au microphone 12b du combiné 12. Chaque impulsion de test est reçue, remise en forme et retransmise par l'unité de référence 1 tel qu'indiqué plus haut en référence à la Figure 3. Chaque impulsion de test retransmise par l'unité de référence 1 est reçue par la partie de réception du modem 52 et délivrée par une liaison 53 à travers les contacts 61a du commutateur 61 en position de "TEST" à un détecteur 54. Le détecteur 54 détecte le temps de propagation 2 Δt requis par une impulsion de test pour effectuer un trajet aller et retour entre l'unité de vérification et l'unité de référence, c'est-à-dire deux trajets aller entre ces unités.

A l'aide d'une bascule monostable, le module de test 50 délivre des impulsions ayant une largeur 2 Δt représentative du temps de propagation aller et retour de chaque impulsion de test, par une liaison 77 au détecteur 54. Il est à noter que chaque impulsion 2 Δt est produite par le module de test au moment où est générée une impulsion de test. Un potentiomètre multi-tours 57 est prévu pour ajuster la largeur de l'impulsion 2 Δt à la sortie du module de test. Evidemment, le temps entre deux impulsions de test générées par le module de test via la liaison 51 est plus long que le temps nécessaire à chaque impulsion pour effectuer le trajet aller et retour dans la liaison téléphonique 6 des Figures 1 et 2. Le détecteur 54 allume, par l'intermédiaire d'un inverseur 55, une lampe ou LED représentée schématiquement en 56, lorsque le front descendant des impulsions 2Δt correspond en moyenne à l'arrivée des impulsions de test, c'est-à-dire lorsque la largeur des impulsions 2 Δt correspond en moyenne au temps de propagation aller et retour de chaque impulsion de test. L'allumage de la lampe ou LED 56 indique donc que la valeur moyenne du temps de propagation du signal numérique à fréquence nominale représentatif de la tension alternative de la phase de référence, de l'unité de référence à l'unité de vérification, est compensée par l'ajustement du potentiomètre multi-tours 57, ce temps de propagation variant, comme indiqué ci-dessus, avec le glissement de phase de ce signal numérique transmis. Si le temps moyen de propagation n'est pas compensé correctement, la lampe ou LED 56 clignote. Evidemment, l'ajustement du potentiomètre multi-tours 57 donne une valeur pour le temps de propagation aller et retour des impulsions de test qui est une moyenne des valeurs de temps de propagation aller et retour mesurées tout au long de l'ajustement de ce potentiomètre multi-tours.

- 14 -

Les impulsions 2 Δt sont tranmsises du module de test du compensateur 63 qui, lorsque le commutateur 61 retourne à la position "NORMAL", établit une valeur égale à la moitié de la largeur des impulsions 2 Δt, c'est-à-dire un temps de propagation moyen dû à la transmission de l'unité de référence à l'unité de vérification à l'aide d'un circuit de comptage recevant des impulsions d'horloge provenant de l'horloge 64. Le compensateur 63 mémorise alors la valeur établie et l'utilise pour compenser le temps moyen de propagation, en retardant le signal numérique à fréquence nominale représentatif de la tension de la phase inconnue. L'unité de vérification est alors prête à identifier la phase inconnue.

La détermination du temps moyen de propagation par l'ajustement du potentiomètre multi-tours 57 doit être effectuée lorsqu'un commutateur 60 est en position "0". Pour compenser des décalages angulaires de ±30° produits par des transformateurs de puissance situés entre les emplacements du réseau triphasé où sont situées les unités de référence et de vérification, le commutateur 60 est positionné en position "1" ou "11" avant de mettre le commutateur 61 en position "NORMAL", c'est-à-dire avant d'effectuer une opération de téléphasage. Selon le cas, le commutateur 60 sélectionne des résistances telles que 58 et 59 afin de modifier convenablement la largeur des impulsions 2Δt pour permettre la compensation du déphasage correspondant produit par ces transformateurs.

Tel que mentionné auparavant, l'ajustement du potentiomètre multi-tours 57 correspond à une valeur moyenne du temps de propagation et le compensateur 63 agit donc de façon à compenser ce temps moyen de propagation. En effet, le temps de propagation varie avec tout glissement de phase du signal représentatif de la tension de la phase de référence lors de sa transmission dans la ligne téléphonique. Il est connu dans la théorie des communications par lignes téléphoniques et par ondes hertziennes, que plusieurs facteurs incontrôlables peuvent influencer ce phénomène de glissement de phase du signal transmis qui varie donc de façon aléatoire.

Comme le glissement de phase défini ci-dessus varie de façon aléatoire, c'est-à-dire de façon non prévisible, le circuit d'inhibition de glissement de phase du détecteur de phase 65 doit avoir une structure permettant de compenser cette variation aléatoire. Une façon de procéder pour le circuit d'inhibition peut être de générer une impulsion d'inhibition ayant une largeur prédéterminée en réponse à chacun des fronts montant et descendant du signal numérique à fréquence nominale représentatif de la tension de la phase de référence reçu par la partie de réception RX du modem 52, et en réponse à chacun des fronts montant et descendant du signal numérique à fréquence nominale représentatif de la tension de la phase inconnue provenant du compensateur 63. Le circuit d'inhibition de glissement de phase comporte un circuit logique qui reçoit et analyse les impulsions d'inhibition pour automatiquement inhiber et ainsi masquer le résultat de la comparaison de phase des deux signaux numériques à fréquence nominale lorsque ces deux signaux sont déphasés d'un angle inférieur à un angle correspondant à la largeur prédéterminée des impulsions d'inhibition, ce déphasage étant dû justement à un glissement de phase du signal numérique à fréquence nominale transmis sur la ligne téléphonique. L'inhibition de la comparaison de phase est maintenue pendant des périodes de temps s'étendant chacune depuis le début de la première des deux impulsions d'inhibition générées en réponse aux fronts montants et descendants correspondants des deux signaux numériques à fréquence nominale appliqués au détecteur 65 jusqu'à la fin de la deuxième de ces deux impulsions d'inhibition.

Il doit être noté que la largeur prédéterminée des impulsions d'inhibition ainsi générées est choisie pour annuler toute erreur sur la comparaison de phase due à tout glissement de phase du signal transmis qui peut se produire sur la ligne téléphonique 6, et cela pour toutes les distances entre les unités de référence et de vérification pour lesquelles le système de téléphasage peut être utilisé.

De cette façon, toute erreur introduite dans la détection de phase par le détecteur 65 par ce glissement de phase, qui peut évidemment se produire dans les deux sens (avance ou retard), se trouve supprimée, en particulier lorsque les tensions des phases de référence et inconnue sont en phase. Evidemment, la largeur prédéterminée des impulsions d'inhibition est limitée pour ne pas empêcher la détection d'un déphasage entre les deux signaux numériques à fréquence nominale représentatifs des tensions des phases de référence et inconnue appliqués au détecteur 65 lorsque ceux-ci correspondent à des phases différentes d'un même réseau triphasé, donc lorsqu'ils sont en réalité déphasés de 120°.

L'unité de vérification comprend également un circuit d'autovérification permettant de vérifier de façon cyclique les principaux organes de cette unité.

L'autovérification est effectuée avec le commutateur 62 en position "AUTOVERIFICATION", et avec le modem 52 fonctionnant en mode vérification et en mode de fréquence origine. Ces modes d'opération permettent que les impulsions de test délivrées par le module de test 50 sont transmises directement par l'air ambiant, du coupleur acoustique de la partie de transmission du modem 52 au coupleur acoustique de la partie de réception de ce modem 52. Evidemment, pour un fonctionnement en autovérification, le combiné du récepteur téléphonique n'est pas couplé aux coupleurs acoustiques du modem 52.

Avec le commutateur 61 en position de "TEST", tel que mentionné précédemment, et le commutateur 60 en position "0", on ajuste le potentiomètre de manière à allumer la lampe ou LED 56. On remet ensuite le commutateur en position "NORMAL". On presse ensuite un bouton poussoir 91 qui met en marche une opération d'autovérification par un séquenceur d'autovérification 92. Le séquenceur 92 a évidemment en mémoire le temps nécessaire aux impulsions de test délivrées par le module 50 pour être propagées par l'air ambiant tel que décrit précédemment.

Après avoir mis le commutateur 61 en position "NORMAL" et pressé sur le bouton poussoir 91, le séquenceur 92 transmet alors sur une liaison 93 un signal numérique à fréquence nominale, correspondant à la phase A d'un système triphasé, au détecteur 65 et à l'analyseur 66. Le séquenceur 92 transmet également cycliquement sur une liaison 94 trois signaux différents à fréquence nominale correspondant aux phases A, B et C du même système triphasé. La transmission cyclique des phases A, B et C sur la liaison 94 par le séquenceur 92 correspond respectivement aux cycles 1, 2 et 3 de l'autovérification. Le séquenceur 92 déphase également les signaux correspondant aux phases A, B et C transmis sur la liaison 94 d'un angle correspondant au temps ci-dessus mentionné nécessaire à la propagation des impulsions de test à travers l'air ambiant. Le compensateur de temps de propagation 63 annule le temps détecté auparavant par l'ajustement du potentiomètre 57 et transmet le signal présent sur la liaison 94 et donc retardé au détecteur 65 et à l'analyseur 66. Des lampes ou LED représentées schématiquement en 83 à 85 et des inverseurs 87 à 89 indiquent chacun des cycles d'autovérification du séquenceur 92 ci-dessus mentionnés. Des signaux fournis au séquenceur 92 via une liaison 95 par le détecteur de phase 65 permettent de déterminer si l'unité de vérification 2 est en bon état de fonctionnement. Dans l'affirmative, une lampe ou LED représentée schématiquement en 86 est allumée par le séquenceur 92 par l'intermédiaire d'un inverseur 90. Ceci confirme notamment que le comparateur 63 a établi un retard égal au temps de propagation à travers l'air ambiant entre les coupleurs acoustiques, égalité vérifiée par les déphasages de 120° et 240° entre les phases A et B et A et C indiqués par le détecteur 65 et signalés par le séquenceur 92 et la lampe 90.

Lorsque l'on désire effectuer une autre séquence d'autovérification, on a simplement à presser à nouveau le bouton poussoir 91.

L'autovérification décrite ci-dessus vérifie donc le fonctionnement du détecteur 65, de l'analyseur 66, du compensateur 63, du modem 52, du module de test 50, et du détecteur 54 en quelques opérations seulement.

L'unité de vérification comprend également un circuit de détection d'appels téléphoniques 43, des inverseurs 44 et 45, une lampe ou LED représentée schématiquement en 46 et un avertisseur sonore 47 dont les fonctions sont les mêmes que celles explicitées ci-haut en référence au circuit de détection d'appels téléphoniques 19, aux inverseurs 20 et 21, à la lampe ou LED 26 et à l'avertisseur sonore 27 dans la Figure 3.

Des lampes ou LED représentées schématiquement en 80 et 81 sont reliées à des seconds contacts 61b du double commutateur 61 via des inverseurs 78 et 79 pour indiquer les fonctionnements en mode "TEST" et en mode "NORMAL" de l'unité de vérification respectivement.

Les fonctionnements de l'unité de vérification en mode "TELEPHASAGE" pour mesurer et en mode "AUTOVERIFICATION" sont également indiqués par des positions respectives de troisièmes contacts 62c du triple commutateur 62 qui allument soit une lampe ou LED représentée schématiquement en 82 par l'intermédiaire d'un inverseur 104, soit une lampe ou LED représentée schématiquement en 103 par l'intermédiaire d'un inverseur 105.

Un bouton-poussoir 102 connecté à des entrées de contrôle des inverseurs illustrés sur la Figure 4 permet de vérifier le fonctionnement des lampes ou LED de l'unité de vérification et de l'avertisseur sonore 47. Seule l'interconnection de ce bouton-poussoir 102 avec l'inverseur 75 est illustrée à des fins de simplification de la Figure 4.

Evidemment, le fonctionnement du modem 17 de l'unité de référence de la Figure 3 et le fonctionnement du modem 52 de l'unité de vérification de la Figure 4 doivent être conçus de façon à pouvoir effectuer toutes les tâches décrites ci-haut.

L'unité de vérification pourrait éventuellement comprendre un microprocesseur qui effectuerait les fonctions de détection de phase, de mesure et de compensation du temps de propagation, ainsi que l'autovérification réalisée par cette unité de vérification.

Bien entendu, le système de téléphasage selon l'invention fonctionnerait aussi bien si l'unité 1 des Figures 1 et 2 était branchée à la phase inconnue, et l'unité 2 des Figures 1 et 2 à la phase de référence, en interchangeant simplement les lampes ou LED 72 et 74.

Une autre possibilité serait d'inclure aussi bien une unité de référence qu'une unité de vérification dans chacune de deux unités distantes localisées à des emplacements le long de la ligne triphasée à haute tension 3 analogues à ceux des unités 1 et 2 montrées aux Figures 1 et 2. L'identification de la phase inconnue pourrait alors être effectuée aux deux emplacements, c'est-à-dire à l'emplacement de la phase inconnue et à l'emplacement de la phase de référence. Cela diminuerait également les risques d'erreur, car deux unités distantes identifieraient la phase inconnue.

REVENDICATIONS

1 - Système de téléphasage pour identifier une phase inconnue dans un réseau polyphasé de transmission ou de distribution d'énergie électrique (3), par comparaison de ladite phase inconnue avec une phase connue, dite de référence, de ce réseau polyphasé, la phase de référence et la phase inconnue fonctionnant à des tensions alternatives de même fréquence, la phase de référence étant située à un emplacement dudit réseau polyphasé où se trouve la phase inconnue, caractérisé en ce qu'il comprend :

un premier dispositif (1) relié à la phase de référence et un second dispositif (2) relié à la phase inconnue, lesdits premier et second dispositifs (1, 2) comprenant des moyens (17, 11 ; 52, 12) pour établir une liaison de communication (6) entre les deux dispositifs (1,2) ;

l'un (1) desdits premier et second dispositifs constituant un dispositif transmetteur et comprenant des moyens (37, 15) pour acquérir la tension alternative de la phase reliée audit dispositif transmetteur (1) pour produire un premier signal qui est représentatif de cette tension alternative ;

les moyens pour établir ladite liaison comprenant des moyens (17, TX) pour transmettre ledit premier signal représentatif du dispositif transmetteur (1) à l'autre (2) desdits premier et second dispositifs à travers ladite liaison de communication (6) ;

ledit autre dispositif (2) comprenant des moyens (40, 41) pour acquérir la tension alternative de la phase reliée audit autre dispositif (2) pour produire un second signal qui est représentatif de cette tension alternative, et des moyens (65) pour identifier, à partir du premier signal représentatif reçu du dispositif transmetteur (1) et du second signal représentatif, la phase inconnue par une détection d'un angle de phase entre la tension alternative de la phase inconnue et la tension alternative de la phase de référence ;

ledit système de téléphasage comprenant également des moyens (63) pour compenser un temps de propagation dudit premier signal représentatif transmis à travers ladite liaison (6) du dispositif transmetteur (1) audit autre dispositif (2), afin d'éviter toute erreur introduite par ce temps de propagation dans la détection dudit angle de phase.

2 - Système de téléphasage selon la revendication 1, caractérisé en ce que lesdits moyens pour établir ladite liaison de communication comprennent un modem (17 ; 52) pour chacun desdits premier et second dispositifs (1 ; 2), les modems (17 ; 52) comportant des moyens (11, 9 ; 12, 10) permettant d'établir une liaison téléphonique (6) entre lesdits premier et second dispositifs (1 ; 2), cette liaison téléphonique constituant ladite liaison de communication.

3 - Système de téléphasage selon la revendication 2, caractérisé en ce que lesdits moyens permettant d'établir la liaison téléphonique comprennent pour chaque modem (17, 52) des moyens de couplage à un récepteur téléphonique (11 ; 12) muni d'un microphone (11b ; 12b) etd'un écouteur (11a, 12a), lesdits moyens de couplage comportant un premier et un second coupleurs acoustiques (9 ; 10) et des moyens pour coupler acoustiquement le microphone et l'écouteur du récepteur téléphonique avec les premier et second coupleurs acoustiques, respectivement, en vue d'établir ladite liaison téléphonique (6) entre les premier et second dispositifs (1 ; 2).

4 - Système de téléphasage selon la revendication 3, caractérisé en ce qu'au moins un dispositif (1 ; 2) parmi les premier et second dispositifs comprend des moyens (19, 27 ; 43, 47) pour détecter un découplage entre le microphone (12b ; 11b) et l'écouteur (12a ; 11a) du récepteur téléphonique (12 ; 11) associé à l'autre dispositif (2 ; 1) parmi lesdits premier et second dispositifs, et les premier et second coupleurs acoustiques (10 ; 9) du modem (52 ; 17) de cet autre dispositif (2 ; 1).

5 - Système de téléphasage selon la revendication 4, caractérisé en ce que lesdits moyens pour détecter un découplage constituent des moyens (19 ; 43) pour détecter un appel téléphonique, le modem (17 ; 52) dudit au moins un dispositif (1 ; 2) ayant des moyens (RX) pour délivrer un signal de sortie (CF) indiquant s'il reçoit ou non une onde porteuse transmise par le modem (52 ; 17) du dispositif (2 ; 1) où se produit ledit découplage, à travers la liaison téléphonique (6), lesdits moyens pour détecter un appel téléphonique incluant un circuit (19 ; 43) recevant ledit signal de sortie (CF) et activant un avertisseur sonore (27 ; 47), lorsque ledit signal de sortie indique que le modem (17 ; 52) dudit au moins un dispositif (1 ; 2) ne reçoit pas ladite onde porteuse transmise par le modem (52 ; 17) du dispositif (2 ; 1) où se produit ledit découplage à cause dudit découpage qui coupe la liaison téléphonique (6) entre les premier et second dispositifs (1 ; 2) et ainsi la transmission de ladite onde porteuse, pour indiquer qu'un opérateur du dispositif (2 ; 1) où se produit ledit découplage veut communiquer avec un opérateur dudit au moins un dispositif (1 ; 2).

6 - Système de téléphasage selon la revendication 1, caractérisé en ce que les moyens pour acquérir dans le dispositif transmetteur (1) comportent des moyens ·(37) pour réduire l'amplitude de la tension alternative de la phase reliée à ce dispositif transmetteur.

7 - Système de téléphasage selon la revendication 6, caractérisé en ce que les moyens pour réduire l'amplitude comprennent un transformateur abaisseur de tension (37) connecté par l'intermédiaire d'un autre transformateur abaisseur de tension (4) à ladite phase qui est reliée au dispositif transmetteur (1).

8 - Système de téléphasage selon la revendication 6, caractérisé en ce que les moyens pour acquérir dans le dispositif transmetteur (1) comportent également des moyens (15) pour transformer la tension alternative dont l'amplitude est réduite, en un signal numérique constituant ledit premier signal représentatif et ayant une fréquence égale à la fréquence de la tension alternative de la phase reliée au dispositif transmetteur (1).

9 - Système de téléphasage selon la revendication 8, caractérisé en ce que le dispositif transmetteur (1) comprend un bâton de phasage connecté à la phase qui est reliée à ce dispositif transmetteur, le bâton de phasage constituant lesdits moyens pour réduire l'amplitude, et un adaptateur de bâton de phasage recevant la tension dont l'amplitude est réduite et comprenant des moyens pour compenser un déphasage produit par le bâton de phasage ainsi que lesdits moyens pour transformer cette tension dont l'amplitude est réduite en un signal numérique qui est délivré par une sortie (14) de l'adaptateur de bâton de phasage.

10 - Système de téléphasage selon la revendication 9, caractérisé en ce que le dispositif transmetteur (1) comporte des moyens (16) pour isoler ladite sortie (14) de l'adaptateur de bâton de phasage du reste du circuit du dispositif transmetteur (1).

11 - Système de téléphasage selon l'une quelconque des revendications 6 à 10, caractérisé en ce que les moyens pour acquérir dans ledit autre dispositif (2) comportent des moyens (40) pour réduire l'amplitude de la tension alternative de la phase reliée à cet autre dispositif.

12 - Système de téléphasage selon la revendication 11, caractérisé en ce que les moyens pour réduire l'amplitude comprennent un transformateur abaisseur de tension (40) connecté par l'intermédiaire d'un autre transformateur abaisseur de tension (5) à la phase qui est reliée audit autre dispositif (2).

13 - Système de téléphasage selon la revendication 11, caractérisé en ce que les moyens pour acquérir dans ledit autre dispositif (2) comportent également des moyens (41) pour transformer la tension alternative dont l'amplitude est réduite, en un signal numérique constituant ledit second signal représentatif et ayant une fréquence égale à la fréquence de la tension alternative de la phase reliée à cet autre dispositif (2).

14 - Système de téléphasage selon la revendication 13, caractérisé en ce que ledit autre dispositif comprend un bâton de phasage (7) connecté à la phase qui est reliée à cet autre dispositif, le bâton de phasage (7) constituant lesdits moyens pour réduire l'amplitude, et un adaptateur de bâton de phasage (8) recevant la tension dont l'amplitude est réduite et comprenant des moyens pour compenser un déphasage produit par le bâton de phasage ainsi que lesdits moyens pour transformer cette tension dont l'amplitude est réduite en un signal numérique qui est délivré par une sortie de l'adaptateur de bâton de phasage (8).

15 - Système de téléphasage selon la revendication 14, caractérisé en ce que ledit autre dispositif (2) comporte des moyens (42) pour isoler ladite sortie (39) de l'adaptateur de bâton de phasage (8) du reste du circuit dudit autre dispositif (2).

- 24 -

16 - Système de téléphasage selon la revendication 1, caractérisé en ce que les moyens pour acquérir dans le dispositif transmetteur (1) comprennent des moyens (37, 15) pour transformer la tension alternative de la phase reliée au dispositif transmetteur (1) en un premier signal numérique périodique ayant une fréquence égale à la fréquence de la tension alternative de la phase reliée audit dispositif transmetteur (1), ledit premier signal numérique constituant ledit premier signal représentatif, et en ce que les moyens pour acquérir dudit autre dispositif (2) comprennent des moyens (40, 41) pour transformer la tension alternative de la phase reliée audit autre dispositif (2) en un second signal numérique périodique ayant une fréquence égale à la fréquence de la tension alternative de la phase reliée audit autre dispositif (2), ledit second signal numérique constituant ledit second signal représentatif, lesdits premier et second signaux numériques tenant compte respectivement des alternances positives ou négatives de la tension alternative de la phase reliée au dispositif transmetteur (1) et des alternances positives ou négatives de la tension alternative de la phase reliée audit autre dispositif (2).

17 - Système de téléphasage selon la revendication 16, caractérisé en ce que lesdits moyens pour compenser comprennent des moyens (63) pour retarder le second signal numérique d'une période de temps égale à une valeur moyenne du temps de propagation du premier signal numérique transmis par le dispositif transmetteur (1) audit autre dispositif (2) à travers ladite liaison de communication (6).

18 - Système de téléphasage selon la revendication 17, caractérisé en ce que lesdits moyens pour identifier dans ledit autre dispositif (2) comprennent des moyens (65) pour détecter un angle de phase entre le premier signal numérique et le second signal numérique retardé.

19 - Système de téléphasage selon la revendication 18, caractérisé en ce que lesdits moyens pour détecter un angle de phase (65) comprennent des moyens pour compenser un glissement de phase du premier signal numérique se produisant lors de la transmission dudit premier signal numérique à travers ladite liaison de communication (6), lesdits moyens pour compenser le glissement de phase comprenant des moyens pour masquer le résultat de la détection d'un angle de phase entre le premier signal numérique et le second signal numérique retardé lorsque l'angle de phase entre le premier signal numérique et le second signal numérique retardé est inférieur à une valeur prédéterminée.

20 - Système de téléphasage selon la revendication 19, caractérisé en ce que lesdits moyens pour identifier comprennent également un dispositif d'affichage (67 à 74), contrôlé par le résultat masqué ou non de la détection d'un angle de phase réalisé par lesdits moyens (65) pour détecter d'un angle de phase entre le premier signal numérique et le second signal numérique retardé, pour indiquer si la tension de la phase inconnue est en phase ou non avec la tension de la phase de référence, le dispositif d'affichage comprenant également des moyens (71 à 74) également contrôlés par ledit résultat masqué ou non de la détection d'un angle de phase réalisée par les moyens pour détecter d'un angle de phase entre le premier signal numérique et le second signal numérique retardé, pour indiquer si la phase de la tension de la phase inconnue est en avance ou en retard par rapport à la phase de la tension de la phase de référence, dans le cas où la tension de la phase inconnue n'est pas en phase avec la tension de la phase de référence.

21 - Système de téléphasage selon l'une quelconque des revendications 17 à 20, caractérisé en ce que lesdits moyens pour compenser comportent, dans ledit autre dispositif (2), des moyens (50) pour générer des impulsions de test successives, lesdits moyens pour établir ladite liaison ayant des moyens (52, TX) pour transmettre les impulsions de test dudit autre dispositif (2) au dispositif transmetteur (1) à travers ladite liaison (6), et, dans le dispositif transmetteur (1), des moyens (18) pour remettre en forme les impulsions de test, lesdits moyens pour établir la liaison téléphonique comprenant des moyens (17, TX) pour retransmettre les impulsions de test remises en forme du dispositif transmetteur (1) audit autre dispositif (2) à travers ladite liaison (6), lesdits moyens pour compenser comportant, dans ledit autre dispositif (2), des moyens (57, 50, 54) pour mesurer un temps moyen de propogation aller et retour desdites impulsions de test entre les deux dispositifs (1, 2), et pour produire un signal représentatif du temps moyen de propagation aller et retour.

22 - Système de téléphasage selon la revendication 21, caractérisé en ce que les moyens pour retarder le second signal numérique (63) comportent, dans ledit autre dispositif (2), un compensateur de temps qui retarde le second signal numérique d'une période de temps égale à une valeur moyenne du temps de propagation du premier signal numérique, établie à partir d'un signal d'horloge et dudit signal représentatif du temps moyen de propagation aller et retour des impulsions de test.

23 - Système de téléphasage selon la revendication 22, caractérisé en ce que le signal représentatif du temps moyen de propagation aller et retour des impulsions de test est une impulsion ayant une largeur représentative de ce temps moyen aller et retour, et en ce que le compensateur de temps (63) comprend des moyens pour mesurer la moitié de ladite largeur afin de déterminer ladite valeur moyenne du temps de propagation du premier signal numérique du dispositif transmetteur (1) audit autre dispositif (2), et des moyens pour mémoriser cette valeur moyenne du temps de propagation du premier signal numérique.

24 - Système de téléphasage selon la revendication 23, caractérisé en ce que les moyens pour compenser comportent des moyens (58, 59, 60) pour modifier la largeur de l'impulsion représentative dudit temps moyen de propagation aller et retour, afin de compenser un déphasage entre la tension alternative de la phase de référence et la tension alternative de la phase inconnue produit par au moins un transformateur situé dans ledit réseau polyphasé (3) entre l'emplacement de la phase de référence et l'emplacement de la phase inconnue.

25 - Système de téléphasage selon l'une quelconque des revendications 1 à 23, caractérisé en ce qu'il comprend également des moyens (50,54 à 56,63) pour compenser un déphasage, entre la tension alternative de la phase de référence et la tension alternative de la phase inconnue, produit par au moins un transformateur situé sur ledit réseau (3) entre l'emplacement de la phase de référence et l'emplacement de la phase inconnue.

26 - Système de téléphasage selon l'une quelconque des revendications 17 à 24, caractérisé en ce que ledit autre dispositif (2) comporte un analyseur de fréquence (66) recevant un signal d'horloge, le premier signal numérique et le second signal numérique retardé pour mesurer les fréquences respectives de ces deux signaux numériques afin de déterminer si ces fréquences se situent à l'intérieur d'une gamme de fréquences déterminée, et ainsi, éviter une identification de la phase inconnue avec des singaux numériques n'ayant pas une fréquence appropriée.

27 - Système de téléphasage selon l'une quelconque des revendication 1 à 26, caractérisé en ce que ledit autre dispositif (2) comporte des moyens d'autovérification (83 à 94) pour vérifier un bon fonctionnement desdits moyens pour établir ladite liaison (52, 12) dans cet autre dispositif, desdits moyens pour compenser (63) et des moyens pour identifier la phase inconnue (65).

28 - Système de téléphasage selon l'une quelconque des revendications 1 et 6 à 24, caractérisé en ce qu'il comporte des moyens (17, 11, 19, 26, 27, 52, 12, 43, 46, 47) permettant à un opérateur du premier dispositif (1) et un opérateur du second dispositif (2) de communiquer entre eux par l'intermédiaire de ladite liaison de communication (6).

29 - Système de téléphasage selon l'une quelconque des revendications 1 à 15, caractérisé en ce que lesdits moyens (63) pour compenser comportent des moyens pour compenser une valeur moyenne du temps de propagation dudit premier signal représentatif, et en ce que les moyens pour identifier (65) comprennent des moyens pour compenser un glissement de phase du premier signal représentatif se produisant lors de la transmission de ce premier signal représentatif par l'intermédiaire de ladite liaison de communication (6), ce glissement de phase influençant ledit temps de propagation du premier signal représentatif.

30 - Procédé de téléphasage pour identifier une phase inconnue dans le réseau polyphasé de transmission ou de distribution d'énergie électrique (3), par comparaison de ladite phase inconnue avec une phase connue, dite phase de référence, dudit réseau polyphasé, la phase de référence et la phase inconnue fonctionnant à des tensions alternatives de même fréquence, la phase de

0146425

- 28 -

référence étant située à un emplacement (4) du réseau polyphasé éloigné par rapport à un autre emplacement (5) de ce réseau où se trouve la phase inconnue, caractérisé en ce qu'il comprend des étapes suivantes :

- établissement d'une liaison de communication (6) entre un premier dispositif (1) relié à la phase de référence et un second dispositif (2) relié à la phase inconnue ;

- production à l'aide de l'un (1) des premier et second dispositifs constituant un dispositif transmetteur (1), d'un premier signal qui est représentatif de la tension alternative de la phase reliée à ce dispositif transmetteur ;

- transmission dudit premier signal représentatif vers l'autre (2) desdits premier et second dispositifs par l'intermédiaire de ladite liaison (6) ;

- production d'un second signal représentatif de la tension alternative de la phase reliée à l'autre dispositif à l'aide dudit autre dispositif (2) ; et

- identification de la phase inconnue par une détection d'un angle de phase entre la tension alternative de la phase inconnue et la tension alternative de la phase de référence, à l'aide dudit autre dispositif (2) et à partir dudit premier signal représentatif que cet autre dispositif reçoit du dispositif transmetteur (1) et dudit second signal représentatif ;

- ledit procédé comprenant également une étape de compensation d'un temps de propagation dudit premier signal représentatif transmis à travers ladite liaison (6) du dispositif transmetteur (1) audit autre dispositif (2), afin d'éviter toute erreur introduite par ce délai de transmission dans la détection dudit angle de phase.

31 - Procédé selon la revendication 30, caractérisé en ce que ladite liaison de communication est une liaison téléphonique (6).

32 - Procédé selon la revendication 30 ou 31, caractérisé en ce que les premier et second signaux représentatifs sont formés respectivement par des premiers et seconds signaux numériques périodiques de même fréquence que les tensions de la phase de référence et de la phase inconnue, et tenant compte des alternances positives ou négatives de ces tensions.

33 - Procédé selon la revendication 32, caractérisé en ce que l'étape de compensation comporte une étape dans laquelle on retarde le second signal numérique d'une période de temps égale à une valeur moyenne du temps de propagation du premier signal numérique à travers ladite liaison (6) du dispositif transmetteur (1) audit autre dispositif (2).

34 - Procédé selon la revendication 32 ou 33, caractérisé en ce que l'étape d'identification comprend une étape de détection d'un angle de phase entre le premier signal numérique et le second signal numérique retardé.

35 - Procédé selon la revendication 34, caractérisé en ce que ladite étape d'identification comporte une étape de compensation d'un glissement de phase du premier signal numérique se produisant lors de la transmission de ce premier signal numérique par l'intermédiaire de ladite liaison de communication (6), ledit glissement de phase influençant le temps de propagation dudit premier signal numérique.

36 - Procédé selon la revendication 35, caractérisé en ce que ladite étape de compensation du glissement comporte une étape où l'on masque le résultat de ladite étape de détection d'un angle de phase entre le premier signal numérique et le second signal numérique retardé lorsque l'angle entre ce premier signal numérique et le second signal numérique retardé est inférieur à une valeur prédéterminée.

37 - Procédé selon l'une quelconque des revendications 33 à 36, caractérisé en ce que ladite étape de compensation comporte préalablement les étapes suivantes :

- génération d'impulsions de test à l'aide dudit autre dispositif (2) ;

- transmission d'impulsions de test générées dudit autre dispositif transmetteur (1) à travers ladite liaison (6) ;

- remise en forme des impulsions de test reçues par le dispositif transmetteur (1) ;

- transmission des impulsions de test remises en forme du dispositif transmetteur (1) audit autre dispositif (2) à travers ladite liaison (6) ;

- mesure d'une valeur moyenne d'un temps de propagation aller et retour des impulsions de test entre le dispositif transmetteur (1) et ledit autre dispositif (2) ; et

- détermination d'une valeur moyenne du temps de propagation du premier signal numérique du dispositif transmetteur (1) audit autre dispositif (2) à partir de ladite valeur moyenne du temps de propagation aller et retour mesurée ;

- ladite étape dans laquelle on retarde le second signal numérique étant telle que ladite période de temps est déterminée par la valeur moyenne dudit temps de propagation.

38 - Procédé selon la revendication 30 ou 31, caractérisé en ce que ladite étape de compensation comporte une étape de compensation d'une valeur moyenne du temps de propagation dudit premier signal représentatif, et en ce que l'étape d'identification comporte une étape de compensation d'un glissement de phase du premier signal représentatif se produisant lors de la transmission de ce premier signal à travers ladite liaison de communication, ce glissement de phase influençant ledit temps de propagation du premier signal représentatif.

0146425

PHASES CONNUES

PHASES INCONNUES

UNITE DE REFERENCE (FIG.3)

UNITE DE VERIFICATION (FIG.4)

LIAISON TELEPHONIQUE

LIGNE TRIPHASEE HAUTE-TENSION

NEUTRE

Fig. 1

Pl. II, 4

PHASE CONNUES

A

B

C

4

PHASES INCONNUES

LIGNE
TRIPHASEE
HAUTE-TENSION
③

A B C

NEUTRE

BATON DE
PHASAGE

7

ADAPTATEUR DE BATON
DE PHASAGE

8

LIAISON
TELEPHONIQUE
⑥

UNITE DE (FIG 3)
REFERENCE

1

9

35

UNITE DE (FIG 4)
VERIFICATION

2

10

49

11a  11

11b

12  12a

12b

**Fig. 2**

0146425

Fig. 3

0146425

Fig. 4

Office européen
des brevets

**RAPPORT DE RECHERCHE EUROPEENNE**

0146425
Numéro de la demande

EP  84 40 2173

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| | | | G 01 R  29/18 |
| Y | US-A-3 027 513  (JAMES E. MULAVEY, FRANK M. HARTZ) <br><br> * Colonne 1, lignes 10-28; colonne 3, lignes 37-70; figures 1,4; colonne 4, lignes 65-75; colonne 5, lignes 1-2 * | 1-3,6, 20,30, 31 | |
| A | | 11,18, 25,34 | |
| | --- | | |
| Y | GB-A-2 083 932  (BERWYN ELMER ETTER) <br><br> * Page 2, lignes 18-32,58-60; figure 6 * | 1-3,6, 20,30, 31 | |
| | --- | | DOMAINES TECHNIQUES RECHERCHES (Int. Cl.4) |
| A | US-A-4 020 287  (ALAN W. WILKERSON) <br> * Figure 2; revendication 1 * | 20 | G 01 R <br> H 04 M <br> H 04 L |
| | --- | | |
| A | DE-A-2 035 598  (SOCIETE ANONYME DE TELECOMMUNICATIONS) | | |
| | --- | | |
| A | FR-A-2 348 500  (ELECTRICITE DE STRASSBOURG) | | |
| | --- | | |
| A | GB-A-1 482 717  (THE ELECTRICITY COUNCIL) | | |
| | ----- | | |

Le présent rapport de recherche a été établi pour toutes les revendications

| Lieu de la recherche <br> LA HAYE | Date d'achèvement de la recherche <br> 20-02-1985 | Examinateur <br> KAUFFMANN J. |
|---|---|---|